# EUROPÄISCHE PATENTANMELDUNG

(11) **EP 2 061 278 A1**
(43) Veröffentlichungstag der Anmeldung: **20.05.2009**
(21) Anmeldenummer: 08167605.8
(22) Anmeldetag: 27.10.2008
(51) Int. Cl.: H04R 25/00, H01L 23/522

(54) **Hörvorrichtungschip mit separater EMV-Masse und entsprechende Hörvorrichtung**

(30) Priorität: 13.11.2007 DE 102007054030
(71) Anmelder: Siemens Medical Instruments Pte. Ltd., Singapore 139959 (SG)
(72) Erfinder: Dickel, Thomas, 96155 Buttenheim (DE); Gottschalk, Georg, 91056 Erlangen (DE); Kasztelan, Thomas, 15741 Bestensee (DE)
(74) Vertreter: Maier, Daniel Oliver

(57) **Zusammenfassung**

Hörvorrichtungen und insbesondere Hörgeräte sollen besser vor elektromagnetischen Störungen geschützt werden. Daher wird ein Hörvorrichtungschip zur Verarbeitung eines Signals einer Hörvorrichtung mit mindestens einem signalverarbeitenden Bauelement (14) und einem ersten Masseleiter (22), der an einen ersten Pol (15) des mindestes einen Bauelements (14) angeschlossen ist, sowie einem zweiten Masseleiter (23), der auf dem Chip von dem ersten Masseleiter (22) galvanisch getrennt und über einen Kondensator (C) an einen zweiten Pol (16) des mindestens einen Bauelements angeschlossen ist, zum Ableiten von Störsignalen aufgrund von elektromagnetischen Einkopplungen bereitgestellt. Insbesondere wird dann nicht die empfindliche Masse eines Vorverstärkers durch Ableitströme gestört.

## Beschreibung

Die vorliegende Erfindung betrifft einen Hörvorrichtungschip zur Verarbeitung eines Signals einer Hörvorrichtung mit mindenstens einem signalverarbeitenden Bauelement und einem Masseleiter, der an einem Pol des mindestens einen Bauelements angeschlossen ist. Darüber hinaus betrifft die vorliegende Erfindung eine Hörvorrichtung mit einem entsprechenden Hörvorrichtungschip. Unter dem Begriff "Hörvorrichtung" wird hier jedes am oder im Ohr tragbare, schallausgebende Gerät, insbesondere eine Hörgerät, ein Headset, Kopfhörer und dergleichen, verstanden.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO), Hörgerät mit externem Hörer (RIC: receiver in the canal) und In-dem-Ohr-Hörgeräte (IdO), z.B. auch Concha-Hörgeräte oder Kanal-Hörgeräte (ITE, CIC), bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder mechanisch oder elektrisch.

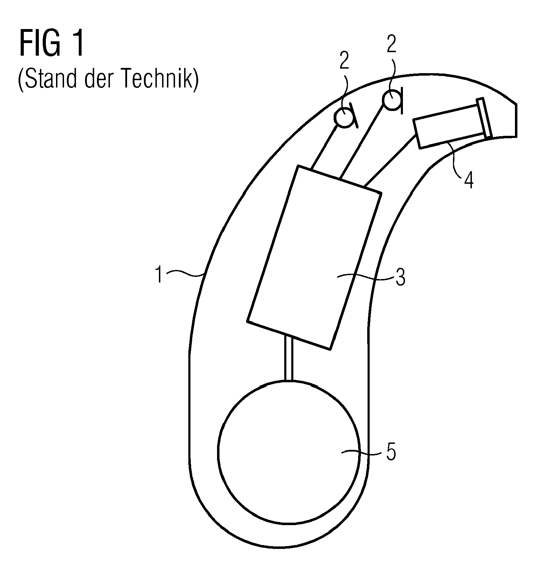

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgeräts dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Stromversorgung des Hörgeräts und insbesondere die der Signalverarbeitungseinheit 3 erfolgt durch eine ebenfalls ins Hörgerätegehäuse 1 integrierte Batterie 5.

In Hörgeräten werden sehr geringe Ströme verarbeitet, weswegen auch die Empfindlichkeit gegenüber Störungen von außen verhältnismäßig hoch ist. Insbesondere können elektromagnetische Strahlen, die von außen einwirken, die Signalverarbeitung eines Hörgeräts beeinträchtigen. Typisches Beispiel hierfür ist die Situation, wenn ein Hörgeräteträger ein Mobiltelefon nutzt. In der Regel werden nämlich die Daten von einem Mobiltelefon oder zu einem Mobiltelefon in Datenpaketen versandt, deren Paketfrequenz im hörbaren Bereich liegt. Daher ist es erforderlich, die elektromagnetische Verträglichkeit (EMV) eines Hörgeräts entsprechend hoch auszulegen und diesbezüglich geeignete Maßnahmen zu ergreifen.

Bislang behalf man sich mit Abschirmungen, um elektromagnetische Strahlen von der Hörgerätesignalverarbeitung fernzuhalten. Alternativ oder zusätzlich werden alle Bauteile, die durch elektromagnetische Störungen verursachte Ströme ableiten sollen, an Masse angeschlossen. An die Masse ist jedoch üblicherweise auch der empfindliche Vorverstärker angeschlossen. Die in der Masse durch Ableitströme verursachten kleinen Spannungsschwankungen wirken sich dann deutlich auf das Ausgangssignal des Vorverstärkers aus.

Die Aufgabe der vorliegenden Erfindung besteht somit darin, die Empfindlichkeit von Hörvorrichtungen gegenüber elektromagnetischen Strahlen zu verringern.

Erfindungsgemäß wird diese Aufgabe gelöst durch einen Hörvorrichtungschip zur Verarbeitung eines Signals einer Hörvorrichtung mit mindestens einem signalverarbeitenden Bauelement und einem ersten Masseleiter, der an einen ersten Pol des mindestens einen Bauelements angeschlossen ist, sowie einem zweiten Masseleiter, der auf dem Chip von dem ersten Masseleiter galvanisch getrennt und über einen Kondensator an einen zweiten Pol des mindestens einen Bauelements angeschlossen ist, zum Ableiten von Störsignalen auf Grund von elektromagnetischen Einkopplungen.

In vorteilhafter Weise ist es durch den separaten zweiten Masseleiter, der eine unabhängige EMV-Masse darstellt, möglich, EMV-Störsignale abzuleiten, ohne dass die Funktionsmasse bestimmter Bauelemente der Hörvorrichtung dadurch beeinträchtigt wäre.

Vorzugsweise ist das signalverarbeitende Bauelement ein Vorverstärker, dessen Signaleingang dem zweiten Pol entspricht. Die über die zusätzliche EMV-Masse abgeleiteten EMV-Störungen wirken sich somit nicht auf den empfindlichen Eingang des Vorverstärkers aus.

Der zweite Masseleiter kann als separate Metalllage oder zumindest als separate Teillage innerhalb des Chips, d.h. der integrierten Schaltung, realisiert sein. Damit wird eine sehr breitflächige Ableitung zur Verfügung gestellt, die nicht nur große schirmende Wirkung, sondern auch von verschiedenen Stellen des Chips leicht erreichbar ist.

Alternativ kann der zweite Masseleiter aber auch als eine in das Chip-Substrat eingebettete Leitung realisiert sein. Dies kann aus Herstellungs- oder Platzgründen notwendig sein, wenn keine komplette Metalllage für die EMV-Masse bereitgestellt werden kann.

Günstigerweise besitzen der erste und der zweite Masseleiter jeweils einen eigenen Anschlusspin. Damit ist speziell auch die EMV-Masse, d.h. der zweite Masseleiter, von außen gut zugänglich.

Entsprechend einer bevorzugten Ausgestaltung ist eine Hörvorrichtung und insbesondere ein Hörgerät mit einer elektrischen Spannungsquelle und einem oben beschriebenen Hörvorrichtungschip vorgesehen. Dabei sind der erste Masseleiter und der zweite Masseleiter jeweils über einen Verbindungsleiter mit einem Massepol der Stromquelle verbunden, und die beiden Verbindungsleiter treffen erst unmittelbar an dem Massepol zusammen. Dies hat zur Folge, dass Ableitströme nicht über wesentliche Passagen der Funktionsmasse, d.h. dem ersten Masseleiter, fließen und die Bauelemente des Chips, aber auch anderer Bauelemente in der Hörvorrichtung nicht beeinträchtigen.

Die vorliegende Erfindung wird anhand der beigefügten Zeichnungen näher erläutert, in denen zeigen:
- FIG 1: den prinzipiellen Aufbau einer Hörvorrichtung gemäß dem Stand der Technik;
- FIG 2: einen Schnitt durch einen erfindungsgemäßen Hörvor- richtungschip und
- FIG 3: ein Schaltbild eines erfindungsgemäßen Verstärker- chips.

Die nachfolgend näher geschilderten Ausführungsbeispiele stellen bevorzugte Ausführungsformen der vorliegenden Erfindung dar.

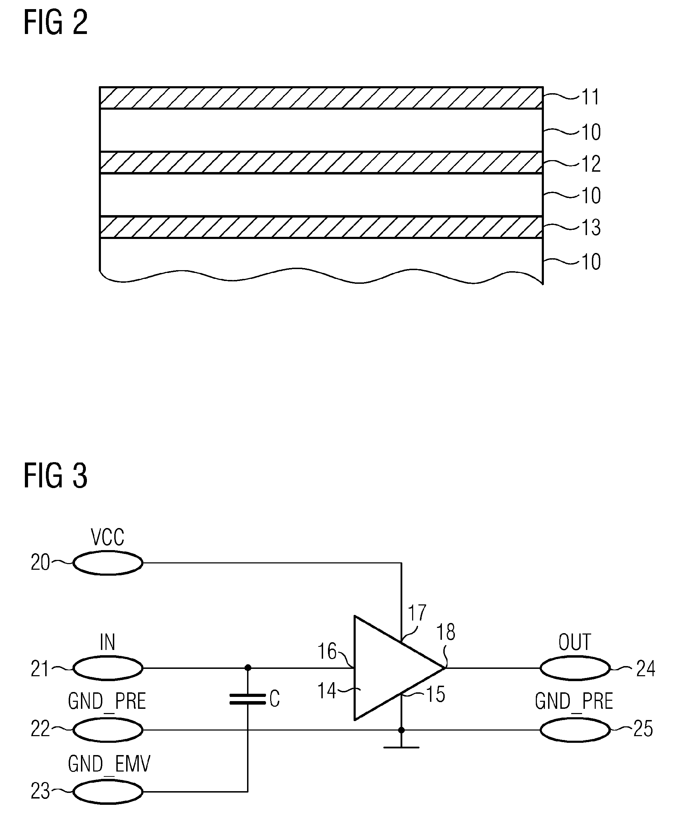

In FIG 2 ist ein erfindungsgemäßer Hörvorrichtungschip in einer Schnittansicht dargestellt. Das Substrat 10 besitzt in dem gewählten Beispiel an seiner Oberfläche eine Metalllage 11, die als Signalleiter für den integrierten Schaltkreis dient. Isoliert durch das Substrat 10 befindet sich unter der Metalllage 11 eine weitere Metalllage 12, die als erster Masseleiter bezeichnet werden kann und die als Masse bzw. Funktionsmasse der integrierten Schaltung dient. Ebenso dient sie als Bezugspotential für die integrierte Schaltung.

Unterhalb der Metalllage 12 ist eine zusätzliche, separate Metalllage 13 angeordnet. Sie ist wiederum durch das Substrat 10 galvanisch von der Metalllage 12 der Masse getrennt. Die zusätzliche Metalllage 13 dient als EMV-Masse. Über sie können Ströme, die durch elektromagnetische Einkopplungen entstanden sind, vom Chip abgeleitet werden. Stehen in dem Chip nicht genügend Metalllagen für eine separate EMV-Masse zur Verfügung, so kann stattdessen auch eine eingebettete, breite Leitung herangezogen werden.

In FIG 3 ist ein Hörgerätechip als einfacher Verstärkerschaltkreis dargestellt. Er dient beispielsweise als Vorverstärker innerhalb eines Hörgeräts. Der dabei verwendete Verstärker 14 besitzt einen ersten Pol 15, der an Masse angeschlossen ist. Die Masse bildet hier die Metalllage 12 des Chips. Zur Kontaktierung der Masse ist eingangsseitig ein Pin 22 (GND_PRE) auf dem Chip vorgesehen. Auf der Ausgangsseite befindet sich ein korrespondierender Pin 25.

Weiterhin besitzt der Verstärker 14 einen zweiten Pol 16, der als Signaleingang dient. Dieser Pol ist entprechend mit einem Eingangspin 21 verbunden. Ein weiterer Pol 17 des Verstärkers 14 dient zur Spannungsversorgung und ist an einen Pin 20 angeschlossen. Das Ausgangssignal des Verstärkers 14 wird an einem weiteren Pol 18 bereitgestellt und zu einem Ausgangspin 24 übertragen. Soweit entspricht der Aufbau einer üblichen Verstärkerschaltung.

Zur Ableitung von Strömen, die durch elektromagnetische Störungen hervorgerufen werden, ist hier nun erfindungsgemäß eine separate Masse (GND EMV) vorgesehen, die wie im Zusammenhang mit FIG 2 bereits erläutert, als eigene Metalllage 13 oder Leitung in dem Substrat 10 realisiert ist. Sie besitzt einen eigenen Anschlusspin 23, über den sie mittels eines Verbindungsleiters beispielsweise an den Minuspol einer Batterie angeschlossen werden kann. Die EMV-Masse bzw. die Metalllage 13 ist außerdem über einen Kondensator C an den Eingang (Eingangspol 16) des Verstärkers 14 gelegt. Über den Kondensator C werden dann hochfrequente Anteile, die in dem Eingangssignal als Störung enthalten sind, an die EMV-Masse abgeleitet. Auf diese Weise ist es möglich, dass die besonders empfindliche Vorverstärkermasse nicht durch elektromagnetische Einstrahlungen beeinträchtigt wird, und das Eingangssignal des Verstärkers 14 somit störungsfrei verstärkt werden kann.

In der Hörvorrichtung bzw. in dem Hörgerät kann die EMV-Masse beispielsweise auch in einer speziell vorgesehenen Lage einer Leiterplatte weiter geführt sein. In diesem Fall wird dann die Metalllage 13 des Chips mit dieser Leiterplattenlage verbunden und letztlich zu dem Minuspol der Batterie geführt.

Zur Vermeidung von Störungen durch elektromagnetische Einstrahlung können auch andere Bauteile im IC (Integrierte Schaltung) impedanzarm d.h. durch breite Leitungen, an die entsprechende Substratebene der EMV-Masse (hier die Masseleitung 13) angeschlossen werden.

## Patentansprüche

1. Hörvorrichtungschip zur Verarbeitung eines Signals einer Hörvorrichtung mit
- mindestens einem signalverarbeitenden Bauelement (14) und
- einem ersten Masseleiter (12), der an einen ersten Pol (15) des mindestens einen Bauelements (14) angeschlossen ist,
**gekennzeichnet durch**
- einen zweiten Masseleiter (13), der auf dem Chip von dem ersten Masseleiter (12) galvanisch getrennt und über einen Kondensator (C) an einen zweiten Pol (16) des mindestens einen Bauelements (14) angeschlossen ist, zum Ableiten von Störsignalen auf Grund von elektromagnetischen Einkopplungen.

2. Hörvorrichtungschip nach Anspruch 1, wobei das signalverarbeitende Bauelement (14) ein Verstärker ist, dessen Signaleingang dem zweiten Pol (16) entspricht.

3. Hörvorrichtungschip nach Anspruch 1 oder 2, wobei der zweite Masseleiter (13) als separate Metalllage oder zumindest als separate Teillage realisiert ist.

4. Hörvorrichtungschip nach Anspruch 1 oder 2, wobei der zweite Masseleiter (13) als eine in das Chip-Substrat (10) eingebettete Leitung realisiert ist.

5. Hörvorrichtungschip nach einem der vorhergehenden Ansprüche, wobei der erste und der zweite Masseleiter (12, 13) jeweils einen eigenen Anschlusspin (22, 23) besitzen.

6. Hörvorrichtung mit einer elektrischen Spannungsquelle und einem Hörvorrichtungschip nach einem der vorhergehenden Ansprüche, wobei der erste Masseleiter (12) und der zweite Masseleiter (13) jeweils über einen Verbindungsleiter mit einem Massepol der elektrischen Spannungsquelle verbunden sind, und die beiden Verbindungsleiter erst unmittelbar an dem Massepol zusammen treffen.
